# DEMANDE DE BREVET EUROPEEN

(11) **EP 4 669 052 A1**
(43) Date de publication de la demande: **24.12.2025**
(21) Numéro de dépôt: 25181977.7
(22) Date de dépôt: 11.06.2025
(51) Int. Cl.: H10D 30/01, H10D 84/83, H10D 84/01, H10D 84/03, H10D 84/85, H10D 88/00

(54) **DISPOSITIF A TRANSISTORS DE TYPE CFET**

(30) Priorité: 18.06.2024 FR 2406481
(71) Demandeur: Commissariat à l'Energie Atomique et aux Energies Alternatives, 75015 Paris (FR)
(72) Inventeur: BARRAUD, Sylvain, 38054 GRENOBLE CEDEX 09 (FR)
(74) Mandataire: Cabinet Beaumont

(57) **Abrégé**

La présente description concerne un dispositif (100) à transistors CFET, comprenant :
- un substrat (102) ;
- une première nanofeuille semi-conductrice (104) et une deuxième nanofeuille semi-conductrice (106);
- une couche isolante (108) disposée entre les première et deuxième nanofeuilles ;
- une première grille (110) disposée autour d'une première partie (112) de la première nanofeuille, et une deuxième grille (114) disposée autour d'une première partie (116) de la deuxième nanofeuille ;
- des premiers espaceurs internes (128) disposés contre des deuxièmes parties (130) de la première nanofeuille entre lesquelles est disposée la première partie de la première nanofeuille, et
- des deuxièmes espaceurs internes (132) disposés contre des deuxièmes parties (134) de la deuxième nanofeuille entre lesquelles est disposée la première partie ;
et dans lequel les premiers et deuxièmes espaceurs internes comportent respectivement des premier et deuxième matériaux diélectriques à faible permittivité et différents l'un de l'autre.

## Description

### Domaine technique

La présente description concerne de façon générale le domaine des dispositifs à transistors de type CFET (« Complementary Field-Effect Transistor » en anglais, ou transistor à effet de champ complémentaire).

### Technique antérieure

Un dispositif à transistors CFET comporte des transistors FET de type N et P superposés l'une au-dessus de l'autre, ou les uns au-dessus des autres, et dont les canaux sont formés par des nanofeuilles (« Nanosheets » en anglais) semi-conductrices empilées. Les grilles de ces transistors entourent les parties des nanofeuilles semi-conductrices qui forment les canaux des transistors, de manière analogue aux transistors de type GAA (« Gate-All Around » en anglais, ou à grille enrobante).

De tels dispositifs à transistors CFET sont par exemple réalisés à partir d'un empilement de couches comprenant une alternance de premières et deuxièmes couches de matériaux pouvant être gravés sélectivement l'un par rapport à l'autre, par exemples des premières couches de silicium et des deuxièmes couches de SiGe. Une couche isolante est disposée entre celles destinées à faire partie du ou des transistors de type N et celles destinées à faire partie du ou des transistors de type P. Une gravure sélective est mise en œuvre telle que des portions restantes des premières couches ou des deuxièmes couches soient destinées à former les canaux des transistors ainsi que des régions d'interface, ou régions de LDD (« Lightly Doped Drain » en anglais, ou drain légèrement dopé) et LDS (« Lightly Doped Source » en anglais, ou source légèrement dopée) destinées à être disposées entre les canaux et les régions de source ou de drain qui sont réalisées ultérieurement. Dans de tels transistors, des espaceurs internes (« inner spacers » en anglais) sont formés autour de ces régions d'interface. De tels transistors sont par exemple décrits dans les documents US 2021/265345 A1 et US 2022/020646 A1.

Les structures des dispositifs à transistors CFET décrits ci-dessus ont toutefois pour inconvénients que les transistors de type N et P ont des canaux comprenant un même matériau semi-conducteur. De plus, dans ces structures, les propriétés électrostatiques des transistors de type P sont nécessairement similaires à celles des transistors de type N compte tenu du procédé mis en œuvre pour leur réalisation. Enfin, les deux transistors de type N et P possèdent également la même orientation cristallographique, ce qui ne permet pas d'optimiser à la fois le transport des électrons pour le transistor de type N et le transport des trous pour le transistor de type P.

### Résumé de l'invention

Il existe un besoin de proposer un dispositif à transistors CFET ne présentant pas au moins une partie des inconvénients ci-dessus, et en particulier permettant une dissociation des propriétés électriques et/ou électrostatiques du ou des transistors de type N vis-à-vis de celles du ou des transistors de type P.

Un mode de réalisation pallie tout ou partie de ces inconvénients et propose un dispositif à transistors à effet de champ complémentaires, comprenant :
- un substrat ;
- au moins une première nanofeuille semi-conductrice et au moins une deuxième nanofeuille semi-conductrice, la première nanofeuille semi-conductrice étant disposée entre la deuxième nanofeuille semi-conductrice et le substrat ;
- une couche isolante disposée entre les première et deuxième nanofeuilles semi-conductrices ;
- une première grille disposée autour d'une première partie de la première nanofeuille semi-conductrice, et une deuxième grille disposée autour d'une première partie de la deuxième nanofeuille semi-conductrice ;
- des premiers espaceurs internes disposés contre des deuxièmes parties de la première nanofeuille semi-conductrice entre lesquelles est disposée la première partie de la première nanofeuille semi-conductrice, et
- des deuxièmes espaceurs internes disposés contre des deuxièmes parties de la deuxième nanofeuille semi-conductrice entre lesquelles est disposée la première partie de la deuxième nanofeuille semi-conductrice ;
   et dans lequel les premiers et deuxièmes espaceurs internes comportent respectivement des premier et deuxième matériaux diélectriques à faible permittivité, les premier et deuxième matériaux diélectriques étant différents l'un de l'autre.

Selon un mode de réalisation particulier, la couche isolante est disposée en regard, ou à l'aplomb, de la totalité des surfaces des premières et deuxièmes nanofeuilles semi-conductrices se trouvant, ou orientées, en regard de la couche isolante.

Selon un mode de réalisation particulier, les première et deuxième nanofeuilles semi-conductrices comportent respectivement des premier et deuxième matériaux semi-conducteurs différents l'un de l'autre.

Selon un mode de réalisation particulier, les première et deuxième nanofeuilles semi-conductrices comportent respectivement des premier et deuxième matériaux semi-conducteurs d'orientations cristallines, ou d'orientations cristallographiques, différentes l'un de l'autre.

Selon un mode de réalisation particulier, les première et deuxième grilles comportent respectivement des premier et deuxième matériaux métalliques différents l'un de l'autre.

Selon un mode de réalisation particulier, au moins une partie de la première grille est en contact avec au moins une partie de la deuxième grille, ou les première et deuxième grilles sont dissociées et isolées l'une de l'autre.

Selon un mode de réalisation particulier, lorsque les première et deuxième grilles sont dissociées et isolées l'une de l'autre, chacune des première et deuxième grilles a une forme de peigne.

Il est également proposé un procédé de réalisation d'un dispositif à transistors à effet de champ complémentaires, comprenant au moins :
- réalisation d'une structure comprenant au moins un substrat, des première et deuxième nanofeuilles semi-conductrices, la première nanofeuille semi-conductrice étant disposée entre la deuxième nanofeuille semi-conductrice et le substrat, et une couche isolante disposée entre les première et deuxième nanofeuilles semi-conductrices ;
- réalisation de premiers espaceurs internes disposés contre des deuxièmes parties de la première nanofeuille semi-conductrice, et de deuxièmes espaceurs internes disposés contre des deuxièmes parties de la deuxième nanofeuille semi-conductrice, les premiers et deuxièmes espaceurs internes comportant respectivement des premier et deuxième matériaux diélectriques à faible permittivité, les premier et deuxième matériaux diélectriques étant différents l'un de l'autre, et telle que les premiers espaceurs internes sont réalisés avant ou après les deuxièmes espaceurs internes ;
- réalisation d'une première grille autour d'une première partie de la première nanofeuille semi-conductrice disposée entre les deuxièmes parties de la première nanofeuille semi-conductrice, et d'une deuxième grille autour d'une première partie de la deuxième nanofeuille semi-conductrice disposée entre les deuxièmes parties de la deuxième nanofeuille semi-conductrice.

Selon un mode de réalisation particulier, la réalisation de la structure comporte au moins :
- réalisation d'un premier empilement de couches comprenant au moins une première couche semi-conductrice disposée entre deux première couches sacrificielles de matériau apte à être gravé sélectivement vis-à-vis de la première couche semi-conductrice, et comprenant une première couche diélectrique ;
- réalisation d'un deuxième empilement de couches comprenant au moins une deuxième couche semi-conductrice disposée entre deux deuxièmes couches sacrificielles de matériau apte à être gravé sélectivement vis-à-vis de la deuxième couche semi-conductrice, et comprenant une deuxième couche diélectrique ;
- solidarisation des première et deuxième couches diélectriques l'une contre l'autre et formant ensemble la couche isolante.

Selon un mode de réalisation particulier, à l'issue de ces étapes, la couche isolante est disposée en regard de la totalité des surfaces des premières et deuxièmes nanofeuilles semi-conductrices se trouvant en regard de la couche isolante.

Selon un mode de réalisation particulier, la réalisation de la structure comprend en outre, après la solidarisation des première et deuxième couches diélectriques l'une contre l'autre, une gravure d'au moins une tranchée mise en œuvre à travers les premier et deuxième empilements de couches et la couche isolante.

Selon un mode de réalisation particulier, la réalisation des deuxièmes espaceurs internes comporte au moins :
- réalisation d'un grille sacrificielle dans la tranchée et sur des portions restantes de la structure obtenues à l'issue de la gravure de la tranchée, puis
- réalisation d'espaceurs de grille autour de la grille sacrificielle, puis
- gravure de parties des portions restantes de la structure non recouvertes par la grille sacrificielle et les espaceurs de grille, à travers les couches du deuxième empilement et une première partie de la couche isolante sans traverser une interface de solidarisation entre les première et deuxième couches diélectriques, puis
- gravure de parties de portions restantes des deuxièmes couches sacrificielles disposées contre les deuxièmes parties de la deuxième nanofeuille semi-conductrice, puis
- réalisation d'une couche du deuxième matériau diélectrique à faible permittivité tel que des portions de cette couche disposées contre des deuxièmes parties de la deuxième nanofeuille semi-conductrice forment les deuxièmes espaceurs internes.

Selon un mode de réalisation particulier, la réalisation des premiers espaceurs internes comportent au moins, après la réalisation de la couche du deuxième matériau diélectrique à faible permittivité :
- gravure de parties des portions restantes de la structure non recouvertes par la grille sacrificielle, les espaceurs de grille et par des parties de la couche du deuxième matériau diélectrique à faible permittivité qui reposent sur une deuxième partie de la couche isolante comprenant l'interface de solidarisation et qui couvrent des extrémités des deuxièmes parties de la deuxième nanofeuille semi-conductrice, à travers les couches du premier empilement et la deuxième partie de la couche isolante, puis
- gravure de parties de portions restantes des premières couches sacrificielles disposées contre les deuxièmes parties de la première nanofeuille semi-conductrice, puis
- réalisation d'une couche du premier matériau diélectrique à faible permittivité tel que des portions de cette couche disposées contre des deuxièmes parties de la première nanofeuille semi-conductrice forment les premiers espaceurs internes.

Selon un mode de réalisation particulier, le procédé comporte en outre, entre la réalisation des premiers et deuxièmes espaceurs internes et la réalisation des première et deuxième grilles :
- réalisation de premières régions de source ou de drain contre des extrémités des deuxièmes parties de la première nanofeuille semi-conductrice, puis
- suppression des parties de la couche du deuxième matériau diélectrique à faible permittivité couvrant les extrémités des deuxièmes parties de la deuxième nanofeuille semi-conductrice, puis
- réalisation de deuxièmes régions de source ou de drain contre des extrémités des deuxièmes parties de la deuxième nanofeuille semi-conductrice.

Selon un mode de réalisation particulier, les réalisations des premières et deuxièmes régions de source ou de drain comportent chacune la mise en œuvre d'une épitaxie, et le procédé comprend en outre, entre les réalisations des premières et deuxièmes régions de source ou de drain, un dépôt d'un matériau d'isolation recouvrant au moins les premières régions de source et de drain.

Selon un mode de réalisation particulier, le procédé comporte en outre, entre la réalisation des premiers et deuxièmes espaceurs internes et la réalisation des première et deuxième grilles ou lors de la réalisation des première et deuxième grilles, une gravure des portions restantes des premières et deuxièmes couches sacrificielles.

Selon un mode de réalisation particulier, la réalisation des premières et deuxièmes grilles comporte une gravure de la grille sacrificielle, puis des dépôts successifs d'au moins un premier matériau métallique formant la première grille et d'au moins un deuxième matériau métallique différent du premier matériau métallique et formant la deuxième grille, et telle qu'au moins une partie de la première grille est en contact avec au moins une partie de la deuxième grille.

Selon un mode de réalisation particulier, la réalisation des premières et deuxièmes grilles comporte :
- une gravure d'une première partie de la grille sacrificielle de manière à former un accès à la première partie de la deuxième nanofeuille semi-conductrice, puis
- un dépôt de matériaux formant la deuxième grille, puis
- une gravure d'une deuxième partie de la grille sacrificielle de manière à former un accès à la première partie de la première nanofeuille semi-conductrice, puis
- un dépôt de matériaux formant la première grille telle que les première et deuxième grilles soient dissociées et isolées l'une de l'autre.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 représente schématiquement une vue en perspective et en coupe d'un dispositif à transistors CFET selon un premier mode de réalisation ;
- la figure 2 représente schématiquement une vue en perspective et en coupe d'un dispositif à transistors CFET selon un deuxième mode de réalisation ;
- la figure 3, la figure 4, la figure 5, la figure 6, la figure 7, la figure 8, la figure 9, la figure 10, la figure 11, la figure 12, la figure 13, la figure 14, la figure 15, la figure 16, la figure 17, la figure 18 et la figure 19 représentent des étapes d'un procédé de réalisation d'un dispositif à transistors CFET selon le premier mode de réalisation ;
- la figure 20, la figure 21, la figure 22 et la figure 23 représentent une partie des étapes d'un procédé de réalisation d'un dispositif à transistors CFET selon le deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans tout le document, les termes « conducteur » et « isolant » sont utilisés pour désigner respectivement une conduction électrique et une isolation électrique.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation telle que représentée sur les figures, dans une position normale d'utilisation du dispositif.

Sauf précision contraire, les expressions "environ", "approximativement", "sensiblement", et "de l'ordre de" signifient à 10 % près, de préférence à 5 % près.

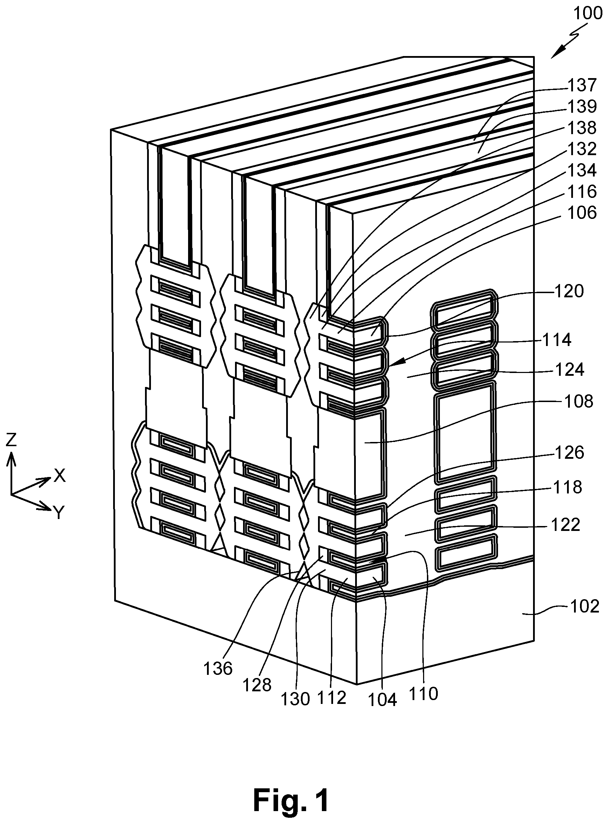

Un exemple de réalisation d'un dispositif 100 à transistors CFET selon un premier mode de réalisation est décrit ci-dessous en lien avec la figure 1.

Le dispositif 100 comporte un substrat 102 sur lequel sont disposées les différentes parties et éléments du dispositif 100. Par exemple, la couche du substrat 102 sur laquelle sont disposés les différentes parties et les différents éléments du dispositif 100 peut correspondre à la couche diélectrique enterrée, ou BOX (« Buried Oxide » en anglais »), d'un substrat de type semi-conducteur sur isolant, par exemple SOI (« Silicon on insulator » en anglais, ou silicium sur isolant), ou bien une région d'isolation de type STI (« Shallow Trench Isolation », ou tranchée d'isolation peu profonde) formée par exemple dans un substrat massif, ou « bulk » en anglais, de semi-conducteur, par exemple de silicium. En variante, un autre type de substrat 102 peut être utilisé pour la réalisation du dispositif 100.

Le dispositif 100 comporte en outre au moins une première nanofeuille semi-conductrice 104 et au moins une deuxième nanofeuille semi-conductrice 106 telles la première nanofeuille semi-conductrice 104 soit disposée entre la deuxième nanofeuille semi-conductrice 106 et le substrat 102. Sur l'exemple de la figure 1, le dispositif 100 comporte plusieurs empilements de plusieurs premières nanofeuilles semi-conductrices 104 au-dessus de chacun desquels est disposé un empilement de plusieurs deuxièmes nanofeuilles semi-conductrices 106. Sur l'exemple de la figure 1, les empilements des premières et deuxièmes nanofeuilles semi-conductrices 104, 106 sont agencés, dans un plan de la face du substrat 102 sur laquelle les empilements de nanofeuilles semi-conductrices 104, 106 sont disposés, en lignes (par exemple parallèlement à l'axe X de la figure 1) et en colonnes (par exemple parallèlement à l'axe Y de la figure 1).

Selon un exemple de réalisation, les première et deuxième nanofeuilles semi-conductrices 104, 106 comportent respectivement des premier et deuxième semi-conducteurs différents l'un de l'autre. Par exemple, le premier semi-conducteur peut être du silicium, et le deuxième semi-conducteur peut être du SiGe. Les premières et deuxièmes nanofeuilles semi-conductrices 104, 106 peuvent toutefois comporter d'autres exemples de semi-conducteurs, comme par exemple du Ge, du GeSn, ou des oxydes de semi-conducteur (IGZO, IWO, ITO, etc.) ou d'autres matériaux III-V (InAS, InGaAs par exemple). Selon un autre exemple de réalisation, les première et deuxième nanofeuilles semi-conductrices 104, 106 comportent des premier et deuxième semi-conducteurs identiques.

Dans une configuration particulière, les orientations cristallines des premier et deuxième semi-conducteurs peuvent être différentes l'une de l'autre. Par exemple, lorsque le premier semi-conducteur des premières nanofeuilles semi-conductrices 104 est destiné à former le canal d'au moins un transistor NFET, son orientation cristalline peut être réalisée selon le plan (100) et la direction [100], ce qui permet de favoriser le transport des électrons dans ce premier semi-conducteur. Lorsque le deuxième semi-conducteur des deuxièmes nanofeuilles semi-conductrices 106 est destiné à former un transistor PFET, son orientation cristalline peut être réalisée selon le plan (110) et la direction [110], ce qui permet de favoriser le transport des trous dans ce deuxième semi-conducteur.

Selon un exemple de réalisation, l'épaisseur (dimension parallèle à l'axe Z sur l'exemple de la figure 1) de chacune des premières et deuxièmes nanofeuilles semi-conductrices 104, 106 peut être comprise entre 5 nm et 20 nm. De plus, la longueur (dimension parallèle à l'axe Y sur l'exemple de la figure 1) de chacune des premières et deuxièmes nanofeuilles semi-conductrices 104, 106 peut être comprise entre 15 nm et 50 nm. Enfin, la largeur (dimension parallèle à l'axe X sur l'exemple de la figure 1) de chacune des premières et deuxièmes nanofeuilles semi-conductrices 104, 106 peut être comprise entre 10 nm et 150 nm.

Le dispositif 100 comporte également une couche isolante 108 disposée entre les première et deuxième nanofeuilles semi-conductrices 104, 106. Sur l'exemple de la figure 1, la couche isolante 108 est disposée entre les empilements des premières nanofeuilles semi-conductrices 104 et les empilements des deuxièmes nanofeuilles semi-conductrices 106. Selon un exemple de réalisation, la couche isolante 108 peut comporter du SiO₂ et une épaisseur (dimension parallèle à l'axe Z sur l'exemple de la figure 1) par exemple comprise entre 10 nm et 100 nm. En variante, la couche isolante 108 peut comporter d'autres exemples de matériau diélectrique et/ou une épaisseur différente de celle indiquée ci-dessus.

En outre, dans l'exemple décrit, la couche isolante 108 est disposée en regard, ou à l'aplomb, de la totalité des surfaces des premières et deuxièmes nanofeuilles semi-conductrices 104, 106 orientées, ou se trouvant, en regard de la couche isolante 108. Autrement dit, une projection des surfaces des premières et deuxièmes nanofeuilles semi-conductrices 104, 106 sur les surfaces de la couche isolante 108 disposées en regard de celles-ci sont égales ou incluses dans lesdites surfaces de la couche isolante 108. Ainsi, la couche isolante 108 s'étend sur ou sous toute la surface des nanofeuilles semi-conductrices 104, 106.

Le dispositif 100 comporte également une première grille 110 disposée autour d'une première partie 112 de la première nanofeuille semi-conductrice 104, et une deuxième grille 114 disposée autour d'une première partie 116 de la deuxième nanofeuille semi-conductrice 106. Sur l'exemple de la figure 1, la première grille 110 est disposée autour des premières parties 112 de chacune des premières nanofeuilles semi-conductrices 104, et la deuxième grille 114 est disposée autour des premières parties 116 de chacune des deuxièmes nanofeuilles semi-conductrices 106. Les premières parties 112, 116 des premières et deuxièmes nanofeuilles semi-conductrices 104, 106 forment les canaux du ou des transistors du dispositif 100. Les première et deuxième grilles 110, 114 peuvent être vues comme formant des grilles au moins partiellement enrobantes.

Dans l'exemple de réalisation décrit, les première et deuxième grilles 110, 114 comportent respectivement des premier et deuxième matériaux métalliques 118, 120 de nature différente l'un de l'autre. Dans le premier mode de réalisation décrit, les premier et deuxième matériaux métalliques 118, 120 sont notamment tels qu'ils présentent un travail de sortie de valeur différente l'un de l'autre.

Sur l'exemple de la figure 1, des parties 122 de la première grille 110 sont en contact avec des parties 124 de la deuxième grille 114, ces parties 122, 124 servant pour accéder électriquement aux grilles 110, 114. Sur l'exemple de la figure 1, ces parties 122, 124 sont localisées entre les lignes et les colonnes d'empilements des premières et deuxièmes nanofeuilles semi-conductrices 104, 106. Dans cet exemple, du fait que les parties 122, 124 des grilles 110, 114 sont contact l'une avec l'autre, elles forment une grille commune aux transistors du dispositif 100. Les premier et deuxième matériaux métalliques 118, 120 peuvent comporter respectivement du TiN et du W, ou bien tout autre matériau adapté tel qu'au moins l'un des matériaux suivants : Al, Ni, Ti, TaN, TiC, TaC, etc.

Sur l'exemple de la figure 1, les première et deuxième grilles 110, 114 comportent également un diélectrique de grille 126 interposé entre les premier et deuxième matériaux métalliques 118, 120 et les autres éléments du dispositif 100. Dans l'exemple de réalisation décrit, le diélectrique de grille 126 est commun aux première et deuxième grilles 110, 114. En variante, le diélectrique de grille de la première grille 110 pourrait être formé par des portions distinctes et non continues par rapport à celles du diélectrique de grille de la deuxième grille 114. Par exemple, le diélectrique de grille 126 peut comporter un matériau diélectrique à forte permittivité tel que du HfSiO₄, du HfO₂, du La₂O₃, du LaAlO₃, du ZrO₂, du ZrSiO₄, du Ta₂O₅, du TiO₂, du SrTiO₃, du Al₂O₃. Un matériau diélectrique à forte permittivité (« High k dielectric » en anglais) peut correspondre à un matériau diélectrique dont la permittivité diélectrique est supérieure à celle du SiO₂, par exemple supérieure à 3,9.

Le dispositif 100 comporte également des premiers espaceurs internes 128 disposés contre de deuxièmes parties 130 de la première nanofeuille semi-conductrice 104 (de chacune des premières nanofeuilles semi-conductrices 104 sur l'exemple de la figure 1) entre lesquelles est disposée la première partie 112 de la première nanofeuille semi-conductrice 104 (de chacune des premières nanofeuilles semi-conductrices 104 sur l'exemple de la figure 1). Le dispositif 100 comporte en outre des deuxièmes espaceurs internes 132 disposés contre de deuxièmes parties 134 de la deuxième nanofeuille semi-conductrice 106 (de chacune des deuxièmes nanofeuilles semi-conductrices 106 sur l'exemple de la figure 1) entre lesquelles est disposée la première partie 116 de la deuxième nanofeuille semi-conductrice 106 (de chacune des premières nanofeuilles semi-conductrices 106 sur l'exemple de la figure 1). Sur l'exemple de la figure 1, les première et deuxièmes parties 112, 130 de chaque première nanofeuille semi-conductrice 104 et les première et deuxième parties 116, 134 de chaque deuxième nanofeuille semi-conductrice 106 sont séparées symboliquement par des traits pointillés. En outre, sur l'exemple de la figure 1, les premiers espaceurs internes 128 sont disposés autour des deuxièmes parties 130 de chacune des premières nanofeuilles semi-conductrices 104, et les deuxièmes espaceurs internes 132 sont disposés autour des deuxièmes parties 134 de chacune des deuxièmes nanofeuilles semi-conductrices 106.

Dans l'exemple décrit, la couche isolante 108 est disposée en regard de la totalité des surfaces des premières et deuxièmes nanofeuilles semi-conductrices 104, 106 orientées, ou se trouvant, en regard de la couche isolante 108, c'est-à-dire des surfaces des premières parties 112, 116 et des deuxièmes parties 130, 134 des premières et deuxièmes nanofeuilles semi-conductrices 104, 106.

Les premiers et deuxièmes espaceurs internes 128, 132 comportent respectivement des premier et deuxième matériaux diélectriques à faible permittivité (« Low k dielectric » en anglais) différents l'un de l'autre, c'est-à-dire des matériaux diélectriques dont la permittivité est inférieure ou égale à celle du nitrure de silicium. Par exemple, les espaceurs internes 128, 132 peuvent comporter au moins l'un des matériaux suivants : SiN, SiOCN, SiBCN, SiOC, SiCN, SiO₂. L'utilisation de tels matériaux diélectriques à faible permittivité pour la réalisation des espaceurs internes 128, 132 a pour avantage de réduire les capacités parasites des transistors du dispositif 100.

Sur l'exemple de la figure 1, le dispositif 100 comporte également des premières régions de source ou de drain 136 s'étendant depuis les extrémités des deuxièmes parties 130 des premières nanofeuilles semi-conductrices 104, et des deuxièmes régions de source ou de drain 138 s'étendant depuis des extrémités des deuxièmes parties 134 des deuxièmes nanofeuilles semi-conductrices 106. Par exemple, les premières ou deuxièmes régions de source ou de drain 136, 138 peuvent comporter du silicium dopé au phosphore lorsqu'elles sont destinées à faire partie d'un transistor de type N, ou peuvent comporter du SiGe dopé au bore lorsqu'elles sont destinées à faire partie d'un transistor de type P.

Sur l'exemple de la figure 1, le dispositif 100 comporte également des espaceurs de grille 137, ainsi qu'un matériau d'isolation 139 disposé entre les lignes d'empilements de nanofeuilles semi-conductrices 104, 106. Les espaceurs internes 128, 132 sont disposés à l'aplomb des espaceurs de grille 137. Les espaceurs de grille 137 peuvent comporter un matériau diélectrique à faible permittivité par exemple identique ou différent de celui ou ceux des espaceurs internes 128, 132, contribuant ainsi à la réduction des capacités parasites des transistors du dispositif 100. Selon un exemple, le matériau d'isolation 139 peut comporter un matériau diélectrique tel que du SiO₂ ou du SiN.

Sur l'exemple de la figure 1, les premières nanofeuilles semi-conductrices 104, la première grille 110, les premiers espaceurs internes 128 et les premières régions de source ou de drain 136 forment au moins un premier transistor FET d'un premier type de conductivité, par exemple un transistor NFET. De plus, les deuxièmes nanofeuilles semi-conductrices 106, la deuxième grille 114, les deuxièmes espaceurs internes 132 et les deuxièmes régions de source ou de drain 138 forment au moins un deuxième transistor FET d'un deuxième type de conductivité opposé au premier type de conductivité, par exemple un transistor PFET.

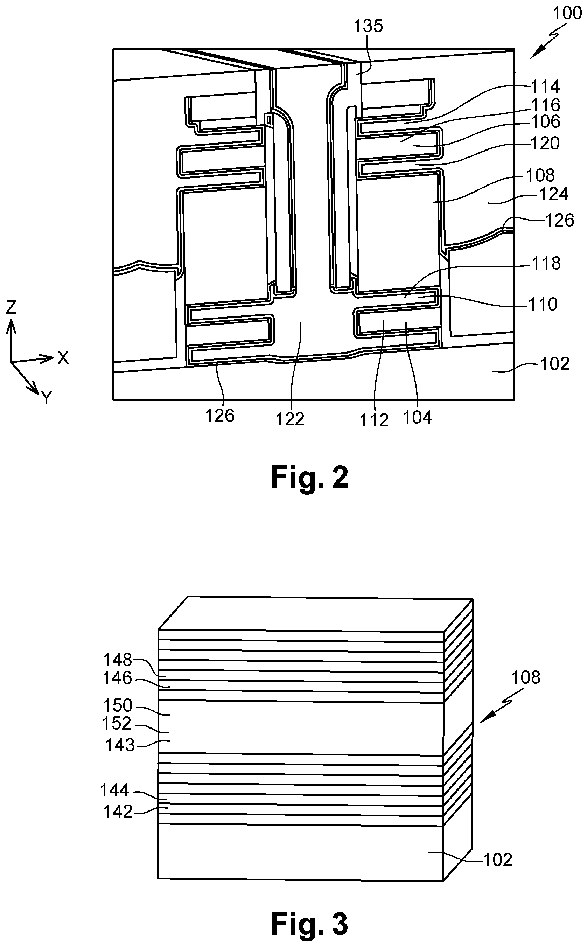

Un exemple de réalisation d'un dispositif à transistors CFET 100 selon un deuxième mode de réalisation est décrit ci-dessous en lien avec la figure 2.

Contrairement au premier mode de réalisation, les première et deuxième grilles 110, 114 sont ici dissociées et isolées l'une de l'autre. Autrement dit, les première et deuxième grilles 110, 114 ne sont pas en contact l'une avec l'autre. Cette dissociation et cette isolation sont obtenues en réalisant les parties 122, 124 servant au contact électrique de ces grilles 110, 114 dans des tranchées différentes formées entre les lignes ou colonnes des empilements des nanofeuilles semi-conductrices 104, 106 (entre les colonnes des empilements des nanofeuilles semi-conductrices 104, 106 sur l'exemple de la figure 2). Dans cette configuration, des portions d'isolation 135, comprenant par exemple du SiN ou tout autre matériau diélectrique adapté, permettent d'isoler électriquement la partie 122 de la première grille 110 vis-à-vis des deuxièmes nanofeuilles semi-conductrices 106.

Dans ce deuxième mode de réalisation, les première et deuxième grilles 110, 114 peuvent être en forme de peignes, comme c'est le cas sur l'exemple de la figure 2, avec les nanofeuilles semi-conductrices 104, 106 disposées entre les dents de ces peignes. De plus, dans cette configuration, pour chaque transistor, un côté du canal n'est pas recouvert par la grille 110, 114 de ce transistor.

Les autres caractéristiques et éléments du dispositif 100 selon le deuxième mode de réalisation sont similaires ou identiques à celles et ceux du premier mode de réalisation.

Un exemple de procédé de réalisation du dispositif 100 selon le premier mode de réalisation est décrit ci-dessous en lien avec les figures 3 à 19.

Tout d'abord, une structure 140 comprenant au moins le substrat 102, les premières et deuxièmes nanofeuilles semi-conductrices 104, 106 et la couche isolante 108 est réalisée.

Cette structure 140 peut être obtenue en réalisant tout d'abord un premier empilement de couches comprenant au moins une première couche semi-conductrice 142 disposée entre deux première couches sacrificielles 144 de matériau apte à être gravé sélectivement vis-à-vis de celui de la première couche semi-conductrice 142, le premier empilement comprenant également une première couche diélectrique 143. La première couche diélectrique 143 comporte par exemple du SiO₂ obtenu par oxydation thermique. Dans l'exemple décrit, étant donné que le dispositif 100 est destiné à comporter plusieurs premières nanofeuilles semi-conductrices 104 empilées, le premier empilement comporte plusieurs premières couches semi-conductrices 142 à partir desquelles les premières nanofeuilles semi-conductrices 104 sont destinées à être réalisées, chacune des premières couches semi-conductrices 142 étant disposée entre deux premières couches sacrificielles 144. En outre, dans cet exemple de réalisation, ce premier empilement est réalisé sur le substrat 102 tel que les premières couches semi-conductrices 142 et les premières couches sacrificielles 144 soient disposées entre le substrat 102 et la première couche diélectrique 143.

Dans cet exemple, un deuxième empilement de couches comprenant au moins une deuxième couche semi-conductrice 146 disposée entre deux deuxièmes couches sacrificielles 148 de matériau apte à être gravé sélectivement vis-à-vis de celui de la deuxième couche semi-conductrice 146 est également réalisé, le deuxième empilement comprenant également une deuxième couche diélectrique 150. La deuxième couche diélectrique 150 comporte par exemple du SiO₂ obtenu par oxydation thermique. Dans l'exemple décrit, étant donné que le dispositif 100 est destiné à comporter plusieurs deuxièmes nanofeuilles semi-conductrices 106 empilées, le deuxième empilement comporte plusieurs deuxième couches semi-conductrices 146 à partir desquelles les deuxièmes nanofeuilles semi-conductrices 106 sont destinées à être réalisées, chacune des deuxièmes couches semi-conductrices 146 étant disposée entre deux deuxièmes couches sacrificielles 148. Selon un exemple, ce deuxième empilement peut être réalisé sur un autre substrat tel que les deuxièmes couches semi-conductrices 146 et les deuxièmes couches sacrificielles 148 soient disposées entre cet autre substrat et la deuxième couche diélectrique 150.

Selon un exemple de réalisation particulier, les premières couches sacrificielles 144 peuvent comporter du SiGe, et les premières couches semi-conductrices 142 peuvent comporter du silicium ou du SiGe avec une concentration en germanium inférieure à celle du SiGe des premières couches sacrificielles 144. Par exemple, les premières couches sacrificielles 144 peuvent comporter du Si_{0,7}Ge_{0,3} et les premières couches semi-conductrices 142 peuvent comporter du Si. De plus, les deuxièmes couches sacrificielles 148 peuvent comporter du SiGe, et les deuxièmes couches semi-conductrices 146 peuvent comporter du silicium ou du SiGe avec une concentration en germanium inférieure à celle du SiGe des deuxièmes couches sacrificielles 148. Par exemple, les deuxièmes couches sacrificielles 148 peuvent comporter du Si_{0,4}Ge_{0,6} et les deuxièmes couches semi-conductrices 146 peuvent comporter du Si_{0,7}Ge_{0,3}. Ces exemples permettent notamment la mise en œuvre d'une gravure sélective des premières couches sacrificielles 144 vis-à-vis des premières couches semi-conductrices 142, et une gravure sélective des deuxièmes couches sacrificielles 148 vis-à-vis des deuxièmes couches semi-conductrices 146. En variante, d'autres matériaux pouvant être gravés sélectivement l'un par rapport à l'autre peuvent être utilisés pour les couches des premier et deuxième empilements.

Dans cette réalisation particulière de la structure 140, une solidarisation des première et deuxième couches diélectriques 143, 150 l'une contre l'autre est ensuite mise en œuvre telle qu'elles forment ensemble la couche isolante 108. L'interface de solidarisation entre les première et deuxième couches diélectriques 143, 150 est désignée par la référence 152. Le substrat utilisé pour la réalisation du deuxième empilement peut ensuite être supprimé, et le substrat 102 est conservé pour servir de support. L'empilement de couches obtenu à ce stade du procédé est représenté sur la figure 3.

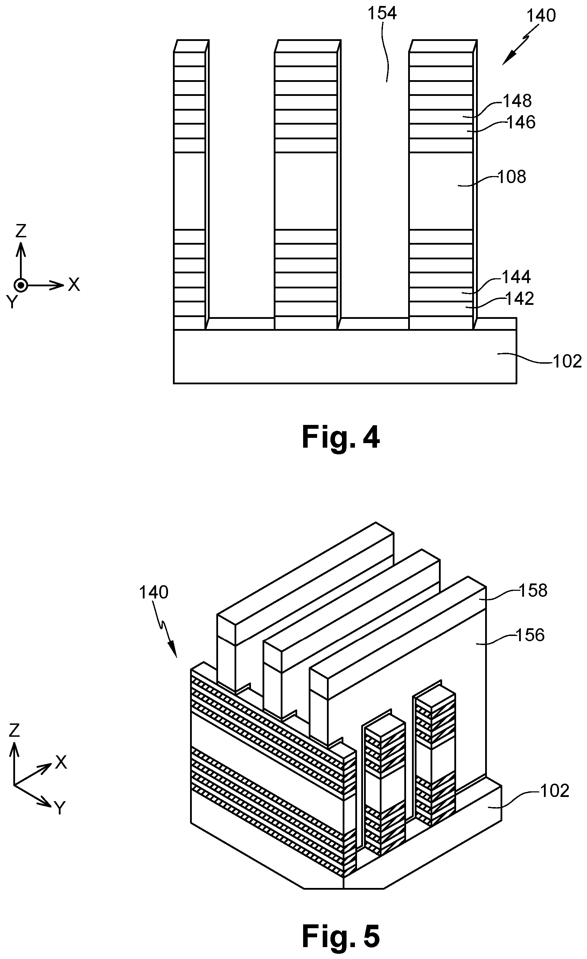

L'empilement de couches obtenu peut ensuite être gravé afin de former des tranchées 154 à travers les empilements de couches 142, 144, 146, 148 et la couche isolante 108 et délimiter les nanofeuilles semi-conductrices 104, 106 selon une première direction (selon l'axe X dans l'exemple décrit). Cette gravure est stoppée sur le substrat 102. La structure 140 obtenue est représentée sur la figure 4.

Le procédé comporte ensuite la réalisation successive des premiers et deuxièmes espaceurs internes 128, 132. Dans l'exemple de réalisation décrit, les deuxièmes espaceurs internes 132 sont réalisés avant les premiers espaceurs internes 128.

Pour réaliser les deuxièmes espaceurs internes 132, une grille sacrificielle 156 est tout d'abord réalisée sur les portions restantes de la structure 140 obtenues à l'issue de la gravure mise en œuvre à travers les empilements de couches 142, 144, 146, 148 et la couche isolante 108. Par exemple, la grille sacrificielle 156 peut être réalisée en mettant en œuvre un premier dépôt d'oxyde, par exemple de SiO₂, suivi d'un dépôt de polysilicium ou de silicium amorphe. Ces couches peuvent ensuite être gravées suivant le motif souhaité pour la grille sacrificielle 156. Un masque de gravure 158 comprenant par exemple du SiN peut être utilisé pour cette gravure. L'ensemble obtenu à ce stade du procédé est représenté sur la figure 5.

Les espaceurs de grille 137 peuvent ensuite être réalisés autour de la grille sacrificielle 156. Le matériau déposé pour former les espaceurs de grille 137 et qui recouvre des parties de l'empilement qui ne sont pas destinées à être recouvertes par les espaceurs de grille peut être supprimé ensuite par gravure, par exemple en mettant en œuvre une gravure sèche telle qu'une gravure plasma anisotrope faisant appel à au moins l'un des gaz suivants : CF₄/O₂/N₂, CF₄/CH₄, SF₆/CH₄, NF₃/CH₄. Le matériau restant forme alors les espaceurs de grille 137.

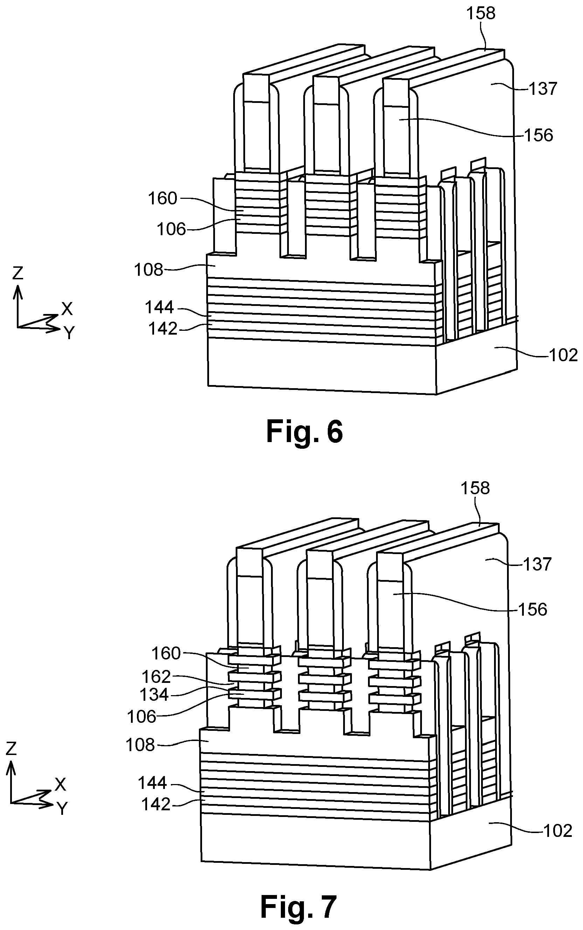

Dans l'exemple de réalisation décrit, une gravure de parties des portions restantes de la structure 140 non recouvertes par la grille sacrificielle 156 et par les espaceurs de grille 137 peut être ensuite mise en œuvre à travers les deuxièmes couches semiconductrices 146 et les deuxièmes couches sacrificielles 148 et une première partie de la couche isolante 108 sans traverser l'interface de solidarisation 152. Cette gravure permet de former notamment les deuxièmes nanofeuilles semi-conductrices 106 chacune disposée entre deux portions restantes 160 des deuxièmes couches sacrificielles 148. Le fait que la gravure ne soit pas mise en œuvre à travers l'interface de solidarisation 152 évite notamment une exposition de cette interface aux chimies de gravure utilisées par la suite. Les deuxièmes nanofeuilles semi-conductrices 106 sont disposées à l'aplomb de parties de la couche isolante 108. La structure obtenue à ce stade du procédé est représentée sur la figure 6.

Dans l'exemple de réalisation décrit, une gravure de parties des portions restantes 160 des deuxièmes couches sacrificielles 148 disposées contre les deuxièmes parties 134 des deuxièmes nanofeuilles semi-conductrices 106 est ensuite mise en œuvre. De plus, cette gravure est ici mise en œuvre telle qu'elle soit sélective vis-à-vis des deuxièmes nanofeuilles semi-conductrices 106. Cette gravure forme des cavités 162 dans lesquelles les deuxièmes espaceurs internes 132 seront réalisés par la suite. En outre, la durée de mise en œuvre de cette gravure détermine les longueurs des cavités 132 le long des deuxièmes nanofeuilles semi-conductrices 106, et également la longueur de canal formé par ces deuxièmes nanofeuilles semi-conductrices 106. La structure obtenue à ce stade du procédé est représentée sur la figure 7.

Dans l'exemple de réalisation décrit, un dépôt d'une couche 164 du deuxième matériau diélectrique à faible permittivité est mis en œuvre tel que des portions de cette couche 164 disposées contre des deuxièmes parties 134 des deuxièmes nanofeuilles semi-conductrices 106, c'est-à-dire dans les cavités 162, forment les deuxièmes espaceurs internes 132. Suivant la nature du matériau déposé pour former cette couche 164, le dépôt mis en œuvre peut être par exemple de type ALD (« Atomic Layer Deposition » en anglais, ou dépôt de couche atomique), LPCVD (« Low-Pressure Chemical Vapor Deposition » en anglais, ou dépôt chimique en phase vapeur à basse pression) ou PECVD (« Plasma-Enhanced Chemical Vapor Deposition » en anglais, ou dépôt chimique en phase vapeur assisté par plasma). Le deuxième matériau diélectrique à faible permittivité de la couche 164 peut être identique ou différent de celui utilisé pour réaliser les espaceurs de grille 137.

Une gravure anisotrope peut ensuite être mise en œuvre pour supprimer des parties de la couche 164 déposées sur la couche isolante 108. Cette gravure correspond par exemple à une gravure sèche mise en œuvre en utilisant par exemple un mélange gazeux de type CH₂F₂/O₂/CH₄/Ar ou un plasma de type CH₃F/O₂/He. En variante, il est possible de réaliser une modification anisotrope de la couche 164 par un plasma de type H₂ ou He, suivie d'une gravure humide mise en œuvre en utilisant par exemple de l'acide fluorhydrique, ou du Hf sous forme de vapeur, ou bien un plasma de type NH₃/NF₃. Il est également possible de mettre en œuvre une seconde gravure isotrope afin de réduire l'épaisseur de la couche 164, par exemple une gravure humide faisant appel à une solution diluée d'acide fluorhydrique ou d'acide phosphorique chaude, cette seconde gravure isotrope étant mise en œuvre sans découvrir les deuxièmes nanofeuilles semi-conductrices 106.

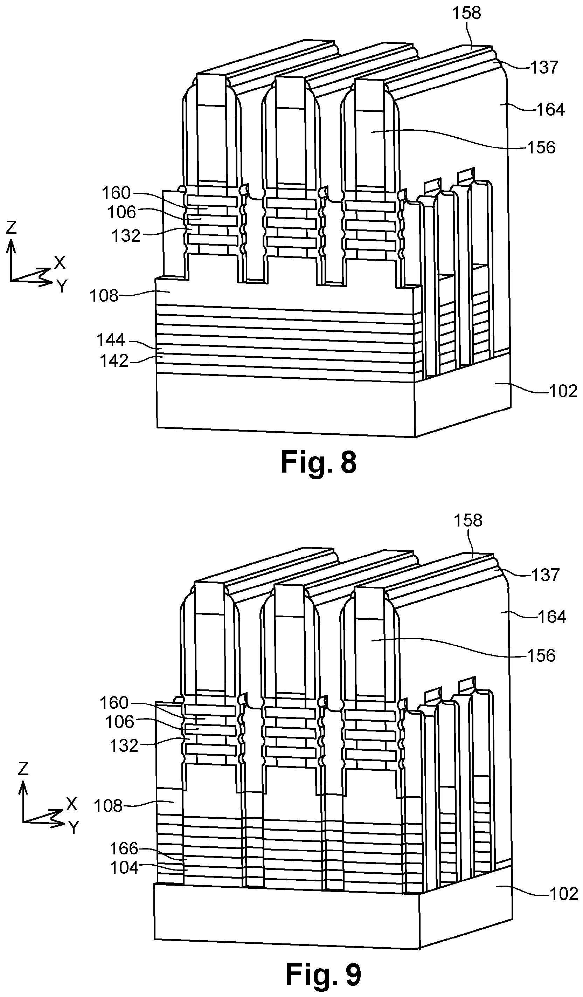

La structure obtenue à ce stade du procédé est représentée sur la figure 8.

Les premiers espaceurs internes 128 sont ensuite réalisés. Pour cela, dans l'exemple de réalisation décrit, une gravure de parties des portions restantes de la structure non recouvertes par la grille sacrificielle 156, par les espaceurs de grille 137 et par des parties de la couche 164 du deuxième matériau diélectrique à faible permittivité peut être mise en œuvre à travers les couches 142, 144 et une deuxième partie de la couche isolante 108 comprenant l'interface de solidarisation 152 (voir figure 9).

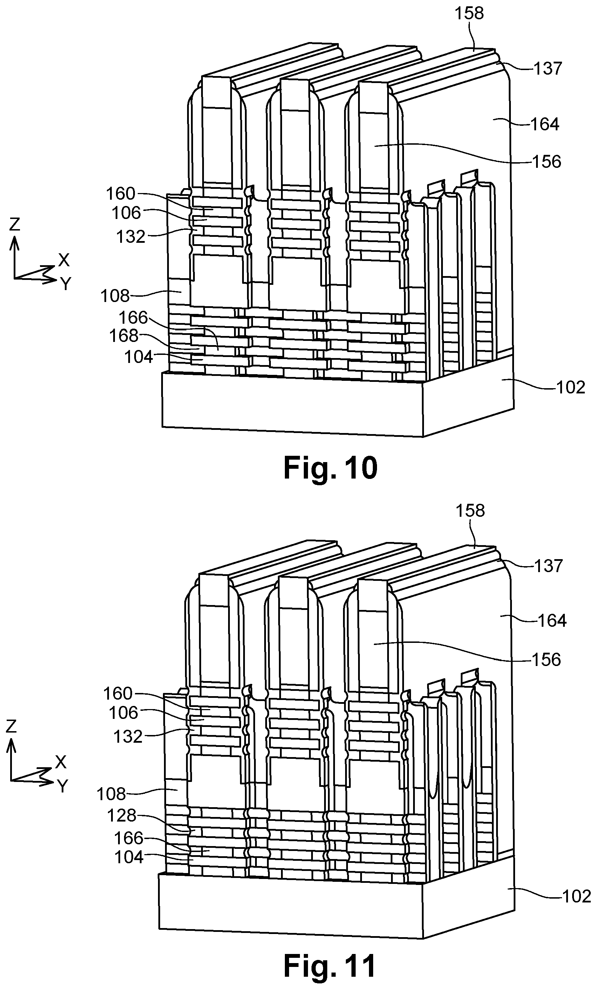

Une gravure de parties de portions restantes 166 des premières couches sacrificielles 144 disposées contre les deuxièmes parties 130 des premières nanofeuilles semi-conductrices 104 peut ensuite être mise en œuvre. Cette gravure est ici mise en œuvre telle qu'elle soit sélective vis-à-vis des premières nanofeuilles semi-conductrices 104. Cette gravure forme des cavités 168 dans lesquelles les premiers espaceurs internes 128 seront réalisés par la suite. En outre, la durée de mise en œuvre de cette gravure détermine les longueurs des cavités 168 le long des premières nanofeuilles semi-conductrices 104, et également la longueur de canal formé par ces premières nanofeuilles semi-conductrices 104. Il est notamment possible que la longueur de canal formé par les premières nanofeuilles semi-conductrices 104 soit différente de celle du canal formé par les deuxièmes nanofeuilles semi-conductrices 106. Comme les deuxièmes nanofeuilles semi-conductrices 106, les premières nanofeuilles semi-conductrices 104 sont disposées à l'aplomb de parties de la couche isolante 108. La structure obtenue à ce stade du procédé est représentée sur la figure 10.

Dans l'exemple de réalisation décrit, un dépôt d'une couche du premier matériau diélectrique à faible permittivité est mis en œuvre tel que des portions de cette couche disposées contre des deuxièmes parties 130 des premières nanofeuilles semi-conductrices 104, c'est-à-dire dans les cavités 168, forment les premiers espaceurs internes 128. Suivant le matériau utilisé pour former les premiers espaceurs internes 128, le dépôt mis en œuvre peut être par exemple de type ALD, LPCVD ou PECVD. Le premier matériau diélectrique à faible permittivité utilisé peut être identique ou différent de celui utilisé pour réaliser les espaceurs de grille 137 et de celui utilisé pour réaliser les deuxièmes espaceurs internes 132.

Une gravure isotrope peut ensuite être mise en œuvre pour supprimer les parties de la couche du premier matériau diélectrique à faible permittivité se trouvant en dehors des cavités 168 et qui ne forment pas les premiers espaceurs internes 128 (voir figure 11).

Ainsi, les différents éléments présents au-dessus de la couche isolante 108, en particulier les deuxièmes nanofeuilles semi-conductrices 106 et les deuxièmes espaceurs internes 132, sont protégés lors des étapes mises en œuvre pour la réalisation des premiers espaceurs internes 128 étant donné que les parties de la couche 164 se trouvant en dehors des cavités 162 sont conservées et protègent ces éléments.

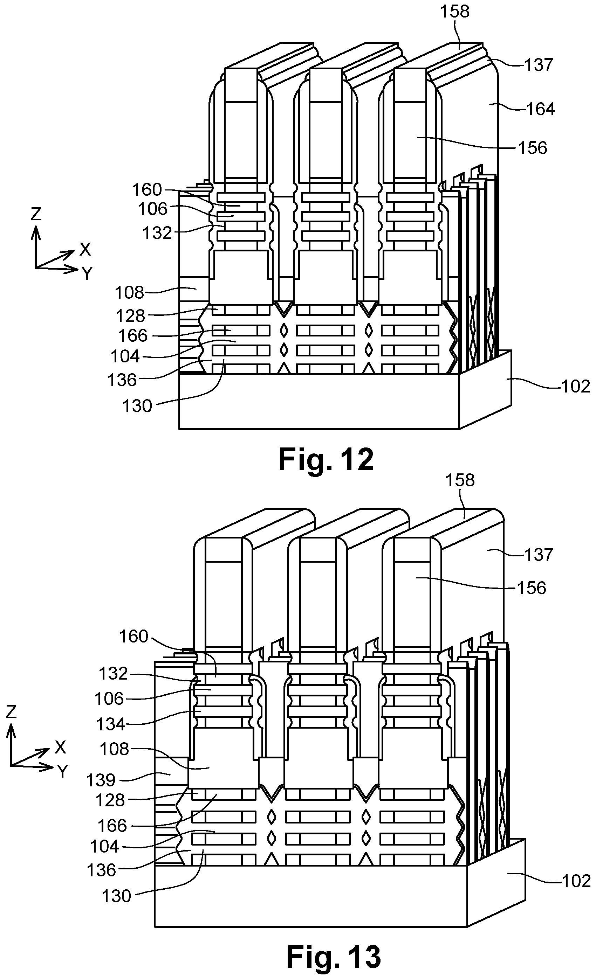

Dans l'exemple de réalisation décrit, les premières régions de source ou de drain 136 sont ensuite réalisées en contact avec des extrémités des deuxièmes parties 130 des premières nanofeuilles semi-conductrices 104 (voir figure 12). Dans l'exemple décrit, ces premières régions de source ou de drain 136 sont réalisées en mettant en œuvre une épitaxie. Cette épitaxie n'impacte pas les deuxièmes nanofeuilles semi-conductrices 106 ni les portions 160 en raison de la couche 164 les recouvrant lors de la mise en œuvre de cette épitaxie.

Dans l'exemple décrit, une couche diélectrique destinée à former le matériau d'isolation 139 est ensuite déposée dans les tranchées 154 en recouvrant les premières régions de source ou de drain 136. Une gravure est ensuite mise en œuvre afin de supprimer les parties de cette couche en contact avec la couche 164. De manière alternative, il est possible de mettre en œuvre une oxydation thermique des premières régions de source ou de drain 136. Une gravure partielle de la couche 164 est ensuite mise en œuvre afin de ne conserver que les deuxièmes espaceurs internes 132 et supprimer notamment les parties de cette couche 164 recouvrant les extrémités des deuxièmes nanofeuilles semi-conductrices 106 (voir figure 13).

Dans l'exemple décrit, les deuxièmes régions de source ou de drain 138 sont ensuite réalisées en contact avec des extrémités des deuxièmes parties 134 des deuxièmes nanofeuilles semi-conductrices 106. Comme pour les premières régions de source ou de drain 136, les deuxièmes régions de source ou de drain 138 peuvent être obtenues en mettant en œuvre une épitaxie.

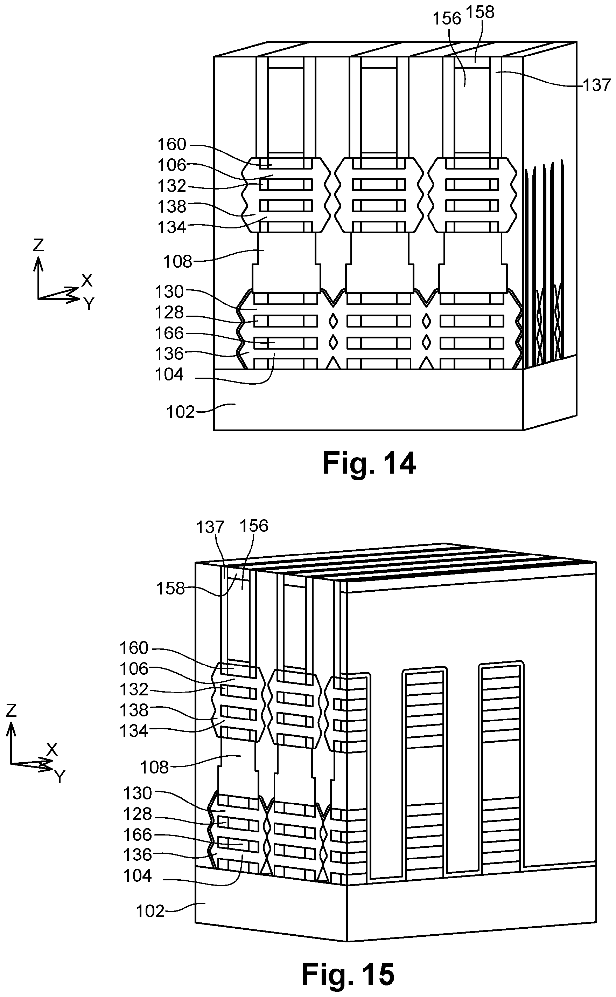

Une couche diélectrique destinée à former le matériau d'isolation 139 peut ensuite être déposée dans les espaces vides restants des tranchées 154, recouvrant ainsi les deuxièmes régions de source ou de drain 138. Une planarisation mécano-chimique (CMP) du matériau déposé en dehors des tranchées 154 peut être mise en œuvre avec arrêt sur le masque 158 (voir figures 14 et 15).

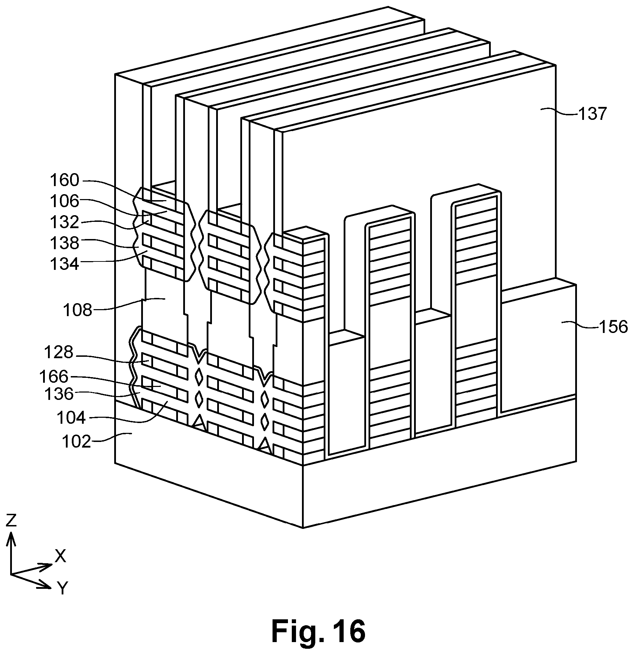

Dans l'exemple décrit, le masque 158 est ensuite retiré, par exemple en mettant en œuvre une gravure sèche ou humide. Une partie de la grille sacrificielle 156 localisée à un niveau au-dessus de l'interface de solidarisation 152 peut ensuite être retirée. Dans l'exemple décrit, seul le polysilicium ou le silicium amorphe de la grille sacrificielle 156 est retiré, l'oxyde de la grille sacrificielle 156 étant conservé (voir figure 16).

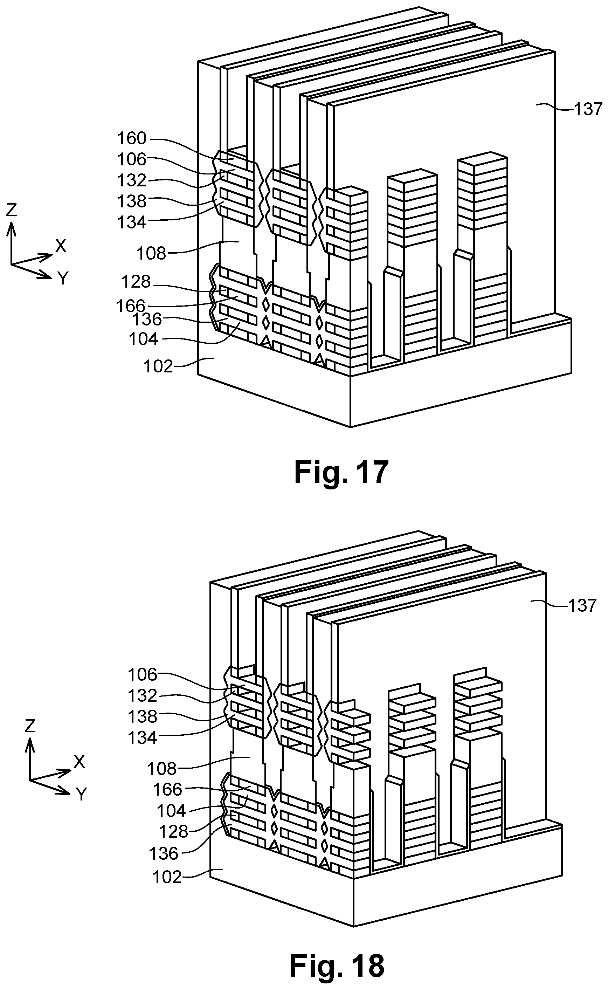

L'oxyde de la grille sacrificielle 156 qui n'est plus recouvert par le polysilicium ou le silicium amorphe de la grille sacrificielle 156 peut ensuite être gravé, puis le reste de polysilicium ou de silicium amorphe de la grille sacrificielle 156 peut être gravé (voir figure 17).

Dans l'exemple de réalisation décrit, une gravure des portions restantes 160 des deuxièmes couches sacrificielles 148 est mise en œuvre sélectivement vis-à-vis des deuxièmes nanofeuilles semi-conductrices 106 (voir figure 18). Lors de cette gravure, les premières nanofeuilles semi-conductrices 104 et les portions restantes 166 des premières couches sacrificielles 144 sont protégées par l'oxyde restant de la grille sacrificielle 156 recouvrant ces éléments.

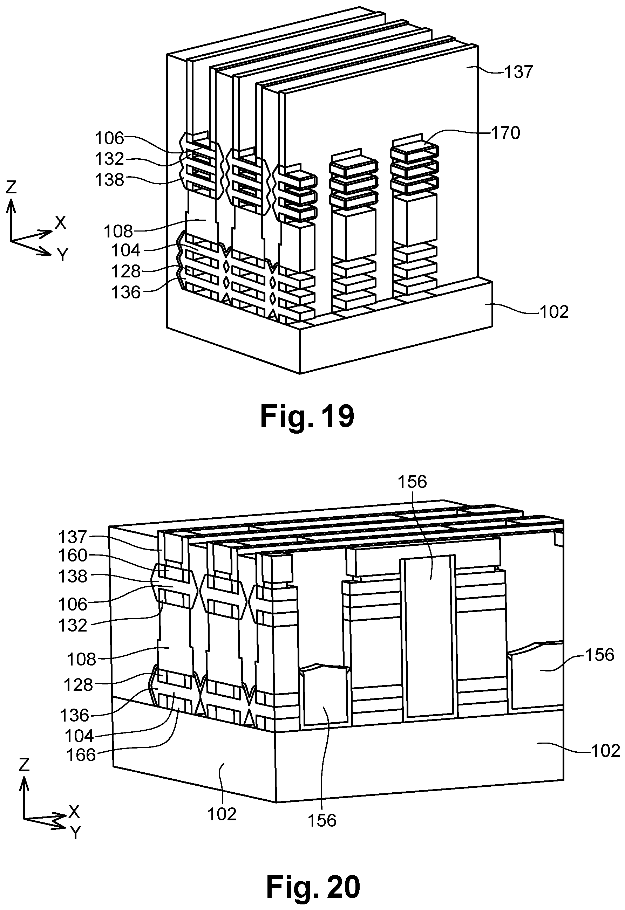

Une couche de protection 170 peut ensuite être formée autour des deuxièmes nanofeuilles semi-conductrices 106. Cette couche de protection 170 peut correspondre à une fine couche de semi-conducteur formée par épitaxie, par exemple comprenant le même matériau que celui des premières nanofeuilles semi-conductrices 104. En variante, cette couche de protection 170 peut être réalisée en mettant en œuvre une oxydation thermique. L'oxyde restant de la grille sacrificielle 156 peut ensuite être gravé, puis les portions restantes 166 des premières couches sacrificielles 144 peuvent être gravées sélectivement vis-à-vis des premières nanofeuilles semi-conductrices 104 (figure 19).

Les première et deuxième grilles 110, 114 sont ensuite réalisées. Dans l'exemple décrit, le diélectrique de grille 126 est tout d'abord déposé, par exemple par la mise en œuvre de l'un des dépôts suivants : CVD (« Chemical Vapor Deposition » en anglais, ou dépôt chimique en phase vapeur), LPCVD, APCVD (« Atmospheric Pressure Chemical Vapor Deposition » en anglais, ou dépôt chimique en phase vapeur à pression atmosphérique), PECVD, ALD. Le premier matériau métallique 118 peut ensuite être déposé. Une gravure humide ou sèche peut ensuite être mise en œuvre pour retirer les parties du premier matériau métallique qui ne sont pas destinées à former la première grille 110. Le deuxième matériau métallique 120 est ensuite déposé pour achever la réalisation de la deuxième grille 114. Une CMP peut ensuite être mise en œuvre pour supprimer les parties non souhaitées du deuxième matériau métallique 120 déposé. Les dépôts mis en œuvre pour déposer les premier et deuxième matériaux métalliques 118, 120 peuvent être de type CVD, LPCVD, APCVD, PECVD, ALD. Le dispositif 100 obtenu correspond à celui précédemment décrit en lien avec la figure 1.

Un exemple de procédé de réalisation du dispositif 100 selon le deuxième mode de réalisation est décrit ci-dessous en lien avec les figures 20 à 23.

Des étapes analogues à celles précédemment décrites en lien avec les figures 1 à 15 sont tout d'abord mises en œuvre. Dans cet exemple, les premières et deuxièmes nanofeuilles semi-conductrices 104, 106 sont formées à partir d'un empilement de couches comprenant une seule première couche semi-conductrice 142 et une seule deuxième couche semi-conductrice 146.

Une première partie de la grille sacrificielle 156 est gravée de manière à former un accès à la première partie 112 de la première nanofeuille semi-conductrice 104. Dans l'exemple décrit, cette gravure est mise en œuvre pour des premières parties de la grille sacrificielle 156 localisées entre deux lignes de nanofeuilles semi-conductrices 104, 106 et en ne gravant pas les parties de la grille sacrificielle 156 localisées entre les lignes adjacentes à celles-ci (voir figure 20).

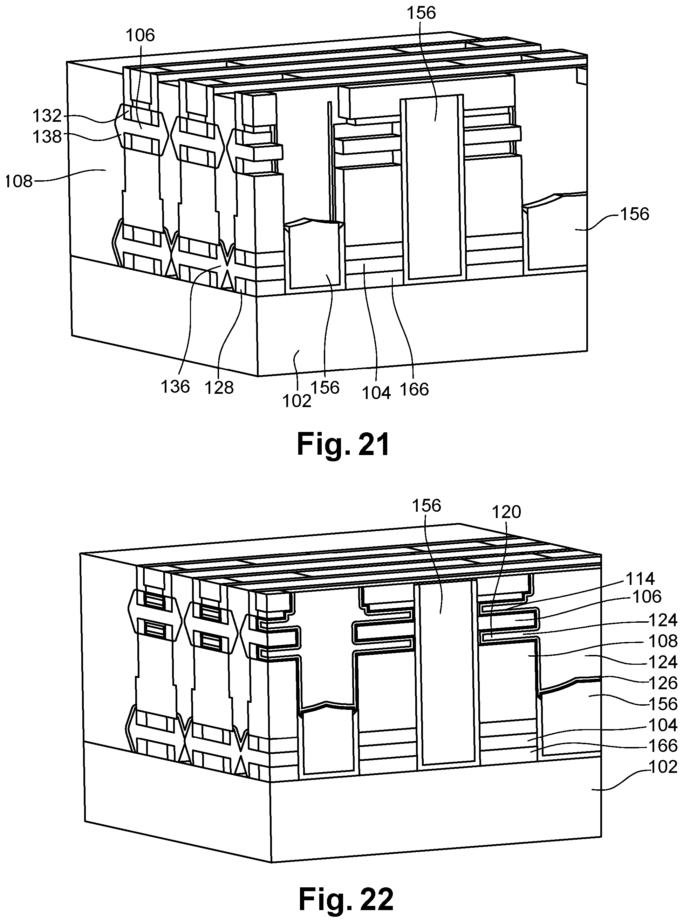

Une gravure des portions restantes 160 des deuxièmes couches sacrificielles 148, sélectivement vis-à-vis des deuxièmes nanofeuilles semi-conductrices 106, peut être mise en œuvre (voir figure 21). Lors de cette gravure, les premières nanofeuilles semi-conductrices 104 et les portions restantes 166 des premières couches sacrificielles 144 sont protégées par les parties de la grille sacrificielle 156 recouvrant ces éléments.

La deuxième grille 114 est ensuite réalisée via le dépôt du diélectrique de grille 126 et du deuxième matériau métallique 120, par exemple identiques à ceux précédemment décrits pour le premier mode de réalisation. Une CMP peut être ensuite mise en œuvre pour supprimer les parties de ces matériaux déposés en excès.

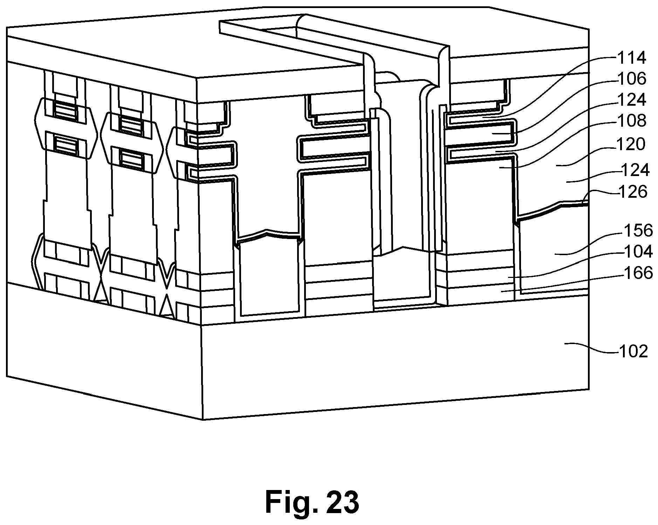

Les parties de la grille sacrificielle 156 occupant les espaces dans lesquels la première grille 110 est destinée à être réalisée peuvent ensuite être supprimées jusqu'à atteindre le niveau auquel se trouve l'empilement des premières nanofeuilles semi-conductrices 104 et les portions restantes 166. Les portions d'isolation 135 peuvent ensuite être réalisées, puis les dernières parties restantes de la grille sacrificielle 156 peuvent être gravées (voir figure 23) .

Dans l'exemple de réalisation décrit, la première grille 110 est ensuite réalisée via le dépôt du diélectrique de grille 126 et le deuxième matériau métallique 120, achevée par une CMP. Le dispositif 100 obtenu correspond à celui visible sur la figure 2.

Dans les différents exemples décrits, des exemples de mises en œuvre de gravure des matériaux diélectriques à faible permittivité sont donnés dans le document US 2013/252430 A1 et peuvent être utilisés dans le procédé décrit ci-dessus.

Dans les différents exemples et modes de réalisation, la couche isolante 108 est disposée en regard de la totalité des surfaces des premières et deuxièmes nanofeuilles semi-conductrices 104, 106 orientées en regard de la couche isolante 108, ce qui permet une réduction significative des capacités parasites au sein du dispositif 100, et donc d'améliorer les performances du dispositif 100. L'obtention d'une telle caractéristique est par exemple possible lorsque la couche isolante 108 est obtenue par solidarisation, par exemple par collage, entre les deux couches isolantes chacune présente sur l'un de deux empilements de nanofeuilles semi-conductrices, et que les parties de cette couche isolante se trouvant à l'aplomb des nanofeuilles semi-conductrices sont conservées jusqu'à la fin de la réalisation du dispositif 100.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus. Par exemple, la nature des dépôts et des gravures mis en œuvre peut être choisie en fonction notamment du ou des matériaux à déposer ou à graver.

## Revendications

1. Dispositif (100) à transistors à effet de champ complémentaires, comprenant :
- un substrat (102) ;
- au moins une première nanofeuille semi-conductrice (104) et au moins une deuxième nanofeuille semi-conductrice (106), la première nanofeuille semi-conductrice (104) étant disposée entre la deuxième nanofeuille semi-conductrice (106) et le substrat (102) ;
- une couche isolante (108) disposée entre les première et deuxième nanofeuilles semi-conductrices (104, 106) ;
- une première grille (110) disposée autour d'une première partie (112) de la première nanofeuille semi-conductrice (104), et une deuxième grille (114) disposée autour d'une première partie (116) de la deuxième nanofeuille semi-conductrice (106) ;
- des premiers espaceurs internes (128) disposés contre des deuxièmes parties (130) de la première nanofeuille semi-conductrice (104) entre lesquelles est disposée la première partie (112) de la première nanofeuille semi-conductrice (104), et
- des deuxièmes espaceurs internes (132) disposés contre des deuxièmes parties (134) de la deuxième nanofeuille semi-conductrice (106) entre lesquelles est disposée la première partie (116) de la deuxième nanofeuille semi-conductrice (106) ;
dans lequel les premiers et deuxièmes espaceurs internes (128, 132) comportent respectivement des premier et deuxième matériaux diélectriques à faible permittivité, les premier et deuxième matériaux diélectriques étant différents l'un de l'autre ;
et dans lequel la couche isolante (108) est disposée en regard de la totalité des surfaces des premières et deuxièmes nanofeuilles semi-conductrices (104, 106) se trouvant en regard de la couche isolante (108).

2. Dispositif (100) selon la revendication 1, dans lequel les première et deuxième nanofeuilles semi-conductrices (104, 106) comportent respectivement des premier et deuxième matériaux semi-conducteurs d'orientations cristallines différentes l'un de l'autre.

3. Dispositif (100) selon l'une quelconque des revendications précédentes, dans lequel les première et deuxième grilles (110, 114) comportent respectivement des premier et deuxième matériaux métalliques (118, 120) différents l'un de l'autre.

4. Dispositif (100) selon l'une quelconque des revendications précédentes, dans lequel au moins une partie (122) de la première grille (110) est en contact avec au moins une partie (124) de la deuxième grille (114), ou dans lequel les première et deuxième grilles (110, 114) sont dissociées et isolées l'une de l'autre.

5. Dispositif (100) selon la revendication 4, dans lequel, lorsque les première et deuxième grilles (110, 114) sont dissociées et isolées l'une de l'autre, chacune des première et deuxième grilles (110, 114) a une forme de peigne.

6. Procédé de réalisation d'un dispositif (100) à transistors à effet de champ complémentaires, comprenant au moins :
- réalisation d'une structure (140) comprenant au moins un substrat (102), des première et deuxième nanofeuilles semi-conductrices (104, 106), la première nanofeuille semi-conductrice (104) étant disposée entre la deuxième nanofeuille semi-conductrice (106) et le substrat (102), et une couche isolante (108) disposée entre les première et deuxième nanofeuilles semi-conductrices (104, 106) ;
- réalisation de premiers espaceurs internes (128) disposés contre des deuxièmes parties (130) de la première nanofeuille semi-conductrice (104), et de deuxièmes espaceurs internes (132) disposés contre des deuxièmes parties (134) de la deuxième nanofeuille semi-conductrice (106), les premiers et deuxièmes espaceurs internes (128, 132) comportant respectivement des premier et deuxième matériaux diélectriques à faible permittivité, les premier et deuxième matériaux diélectriques étant différents l'un de l'autre, et telle que les premiers espaceurs internes (128) sont réalisés avant ou après les deuxièmes espaceurs internes (132) ;
- réalisation d'une première grille (110) autour d'une première partie (112) de la première nanofeuille semi-conductrice (104) disposée entre les deuxièmes parties (130) de la première nanofeuille semi-conductrice (104), et d'une deuxième grille (114) autour d'une première partie (116) de la deuxième nanofeuille semi-conductrice (106) disposée entre les deuxièmes parties (134) de la deuxième nanofeuille semi-conductrice (106) ;
dans lequel, à l'issue de ces étapes, la couche isolante (108) est disposée en regard de la totalité des surfaces des premières et deuxièmes nanofeuilles semi-conductrices (104, 106) orientées en regard de la couche isolante (108) ;
et dans lequel la réalisation de la structure (140) comporte au moins :
- réalisation d'un premier empilement de couches comprenant au moins une première couche semi-conductrice (142) disposée entre deux première couches sacrificielles (144) de matériau apte à être gravé sélectivement vis-à-vis de la première couche semi-conductrice (142), et comprenant une première couche diélectrique (143) ;
- réalisation d'un deuxième empilement de couches comprenant au moins une deuxième couche semi-conductrice (146) disposée entre deux deuxièmes couches sacrificielles (148) de matériau apte à être gravé sélectivement vis-à-vis de la deuxième couche semi-conductrice (146), et comprenant une deuxième couche diélectrique (150) ;
- solidarisation des première et deuxième couches diélectriques (143, 150) l'une contre l'autre et formant ensemble la couche isolante (108).

7. Procédé selon la revendication 6, dans lequel la réalisation de la structure (140) comprend en outre, après la solidarisation des première et deuxième couches diélectriques (143, 150) l'une contre l'autre, une gravure d'au moins une tranchée (154) mise en œuvre à travers les premier et deuxième empilements de couches (142, 144, 146, 148) et la couche isolante (108).

8. Procédé selon la revendication 7, dans lequel la réalisation des deuxièmes espaceurs internes (132) comporte au moins :
- réalisation d'un grille sacrificielle (156) dans la tranchée (154) et sur des portions restantes de la structure (140) obtenues à l'issue de la gravure de la tranchée (154), puis
- réalisation d'espaceurs de grille (137) autour de la grille sacrificielle (156), puis
- gravure de parties des portions restantes de la structure (140) non recouvertes par la grille sacrificielle (156) et les espaceurs de grille (137), à travers les couches (146, 148) du deuxième empilement et une première partie de la couche isolante (108) sans traverser une interface de solidarisation (152) entre les première et deuxième couches diélectriques (143, 150), puis
- gravure de parties de portions restantes (160) des deuxièmes couches sacrificielles (148) disposées contre les deuxièmes parties (134) de la deuxième nanofeuille semi-conductrice (106), puis
- réalisation d'une couche (164) du deuxième matériau diélectrique à faible permittivité tel que des portions de cette couche (164) disposées contre des deuxièmes parties (134) de la deuxième nanofeuille semi-conductrice (106) forment les deuxièmes espaceurs internes (132).

9. Procédé selon la revendication 8, dans lequel la réalisation des premiers espaceurs internes comportent au moins, après la réalisation de la couche (164) du deuxième matériau diélectrique à faible permittivité :
- gravure de parties des portions restantes de la structure (140) non recouvertes par la grille sacrificielle (156), les espaceurs de grille (137) et par des parties de la couche (164) du deuxième matériau diélectrique à faible permittivité qui reposent sur une deuxième partie de la couche isolante (108) comprenant l'interface de solidarisation (152) et qui couvrent des extrémités des deuxièmes parties (134) de la deuxième nanofeuille semi-conductrice (106), à travers les couches (142, 144) du premier empilement et la deuxième partie de la couche isolante (108), puis
- gravure de parties de portions restantes (166) des premières couches sacrificielles (144) disposées contre les deuxièmes parties (130) de la première nanofeuille semi-conductrice (104), puis
- réalisation d'une couche du premier matériau diélectrique à faible permittivité tel que des portions de cette couche disposées contre des deuxièmes parties (130) de la première nanofeuille semi-conductrice (104) forment les premiers espaceurs internes (128).

10. Procédé selon la revendications 9, comportant en outre, entre la réalisation des premiers et deuxièmes espaceurs internes (128, 132) et la réalisation des première et deuxième grilles (110, 114) :
- réalisation de premières régions de source ou de drain (136) contre des extrémités des deuxièmes parties (130) de la première nanofeuille semi-conductrice (104), puis
- suppression des parties de la couche (164) du deuxième matériau diélectrique à faible permittivité couvrant les extrémités des deuxièmes parties (134) de la deuxième nanofeuille semi-conductrice (106), puis
- réalisation de deuxièmes régions de source ou de drain (138) contre des extrémités des deuxièmes parties (134) de la deuxième nanofeuille semi-conductrice (106).

11. Procédé selon la revendication 10, dans lequel les réalisations des premières et deuxièmes régions de source ou de drain (136, 138) comportent chacune la mise en œuvre d'une épitaxie, et comprenant en outre, entre les réalisations des premières et deuxièmes régions de source ou de drain (136, 138), un dépôt d'un matériau d'isolation (139) recouvrant au moins les premières régions de source et de drain (136).

12. Procédé selon l'une quelconque des revendications 9 à 11, comportant en outre, entre la réalisation des premiers et deuxièmes espaceurs internes (128, 132) et la réalisation des première et deuxième grilles (110, 114) ou lors de la réalisation des première et deuxième grilles (110, 114), une gravure des portions restantes (160, 166) des premières et deuxièmes couches sacrificielles (144, 148).

13. Procédé selon l'une quelconque des revendications 8 à 12, dans lequel la réalisation des premières et deuxièmes grilles (110, 114) comporte une gravure de la grille sacrificielle (156), puis des dépôts successifs d'au moins un premier matériau métallique (118) formant la première grille (110) et d'au moins un deuxième matériau métallique (120) différent du premier matériau métallique (118) et formant la deuxième grille (114), et telle qu'au moins une partie (122) de la première grille (110) est en contact avec au moins une partie(124) de la deuxième grille (114).

14. Procédé selon l'une quelconque des revendications 6 à 12, dans lequel la réalisation des premières et deuxièmes grilles (110, 114) comporte :
- une gravure d'une première partie de la grille sacrificielle (156) de manière à former un accès à la première partie (116) de la deuxième nanofeuille semi-conductrice (106), puis
- un dépôt de matériaux formant la deuxième grille (114), puis
- une gravure d'une deuxième partie de la grille sacrificielle (156) de manière à former un accès à la première partie (112) de la première nanofeuille semi-conductrice (104), puis
- un dépôt de matériaux formant la première grille (110) telle que les première et deuxième grilles (110, 114) soient dissociées et isolées l'une de l'autre.
